# EUROPEAN PATENT SPECIFICATION

(11) **EP 1 741 545 B1**
(45) Date of publication and mention of the grant of the patent: **17.07.2013**
(21) Application number: 06121497.9
(22) Date of filing: 13.03.2001
(51) Int. Cl.: B29C 67/00, G03F 7/028

(54) **Compositions for use in three dimensional model printing**
Zusammensetzungen zum dreidimensionalen Drucken eines Modells
Compositions pour l' impression tridimensionnelle d'un modèle

(30) Priority: 13.03.2000 US 188698 P; 10.04.2000 US 195321 P; 12.03.2001 US 803108
(43) Date of publication of application: 10.01.2007
(62) Divisional of application: 01912099.7
(73) Proprietor: Stratasys Ltd., 76124 Rehovot (IL)
(72) Inventor: Napadensky, Eduardo, Netanya 42325 (IL); Gothait, Hanan, Rehovot 76230 (IL)
(74) Representative: Vaughan, Christopher Tammo

(56) References cited:
- EP-A2- 0 393 672
- WO-A1-00/11092

## Description

### FIELD OF THE INVENTION

The present invention relates to three-dimensional (3-D) modeling in general and to methods and compositions for use in 3-D printing of complex structures in particular.

### BACKGROUND OF THE INVENTION

3-D printing, which works by building parts in layers, is a process used for the building up of 3-D models. 3-D printing is relatively speedy and flexible, allowing for the production of prototype parts and tooling directly from a CAD model, for example.

Using 3-D printing enables the manufacturer to obtain a full 3-D model of any proposed product before tooling, thereby possibly substantially reducing the cost of tooling and leading to a better synchronization between design and manufacturing. A lower product cost and improved product quality can also be obtained.

Various systems have been developed for computerized 3-D printing. In US Patent No. 6,259,962 to the Assignees of the present application, there is described an apparatus and a method for 3-D model printing. U.S. Patent No. 6,259,962 describes apparatus including a printing head having a plurality of nozzles, a dispenser connected to the printing head for selectively dispensing interface material in layers, and curing means for optionally curing each of the layers deposited. The depth of each deposited layer is controllable by selectively adjusting the output from each of the plurality of nozzles.

In US Patent No: 6,658,314 to the Assignees of the present invention, there is described an apparatus and a method for 3-D model printing. U.S. Patent 6,658,314 describes a system and a method for printing complex 3-D models by using interface materials having different hardness or elasticity and mixing the interface material from each of the printing heads to control the hardness of the material forming the 3-D model. The construction layers of the model are formed from interface material having a different (harder) modulus of elasticity than the material used to form the release (and support) layers, thereby allowing for the forming of complex shapes.

Radiation curable inks are disclosed in U.S. Patent Nos. 4,303,924, 5,889,084, and 5,270,368. U.S. Patent No. 4,303,924 discloses radiation curable compositions for jet-drop printing containing multifunctional ethylenically unsaturated material, monofunctional ethylenically unsaturated material, a reactive synergist, a dye colorant and an oil soluble salt. U.S. Patent No. 5,889,084 discloses a radiation curable ink composition for ink-jet printing which comprises a cationically photoreactive epoxy or vinyl ether monomer or oligomer, a cationic photo-initiator and a coloring agent. U.S. Patent No. 5,270,368 discloses a UV curable ink composition for ink-jet printing comprising a resin formulation having at least two acrylate components, a photo-initiator and an organic carrier.

The ink compositions disclosed in these references are formulated for use in ink-jet printing. Compositions for ink-jet printing are formulated differently from compositions for building 3-D models, and thus have different properties. For example, high viscosity at room temperature is a desirable property for 3-D objects, and thus compositions for building 3-D models are designed to have a high viscosity at room temperature. In contrast, compositions for ink-jet printing are designed to have low viscosity at room temperature in order to function well in the printing process. None of the above-mentioned references disclose compositions that are especially formulated for 3-D printing.

Radiation curable inks for 3-D objects are disclosed in U.S. Patent No. 5,705,316. U.S. 5,705,316 discloses compounds having at least one vinyl ether group, which also contain in the molecule at least one other functional group such as an epoxy or an acrylate group; compositions comprising these compounds; and methods of producing 3-D objects using these compositions. The compounds of U.S. 5,705,316 are complex molecules that are not readily available and thus need to be especially synthesized, which incurs additional time and costs.

None of the above mentioned references provides simple, easily obtainable curable compositions that are suitable for use in 3-D printing. In addition, the above mentioned references do not provide compositions for use in supporting and/or releasing a 3-D model during construction. Finally, the above mentioned references do not provide methods for 3-D printing, by using interface materials having different hardness or elasticity and by mixing the interface material to control the hardness of the material forming the 3-D model.

WO 00/11092 discloses a selective deposition modeling material having viscosity of less than about 30 mPas (centipoise) at 130°C.

Thus, there is a need for simple, easily obtainable curable compositions, that are specially formulated to construct a 3-D model. There is further a need for simple, easily obtainable curable compositions, that are specially formulated to provide support to a 3-D, by forming support/and or release layers around a 3-D object during construction. Lastly, there is a need for methods of constructing a 3-D by using the above mentioned compositions.

### SUMMARY OF THE INVENTION

The present invention relates to compositions for use in the manufacture of 3-D objects. The present invention further relates to compositions for use as a support and/or release material in the manufacture of said 3-D objects. In the present specification. There is also described a method for the preparation of a 3-D object by 3-D printing, and a 3-D object obtained by said method.

The present invention discloses a composition suitable for support in building a three dimensional object by a method of selective dispensing, said composition comprising:
a reactive component, the reactive component comprises a water-miscible component that after curing is capable of swelling upon exposure to water, alkaline water solution or an acidic water solution;
a photo-initiator;
a non-reactive and low toxicity component;
a surface active agent for reducing surface tension to around 30 dyne/cm; and
a stabilizer;
wherein said composition has a viscosity above 50 cps at room temperature and a viscosity lower than 20 cps at a temperature higher than 60°C.

The composition has a first viscosity above 50 cps at room temperature, and a second viscosity compatible with ink-jet printers at a second temperature, wherein said second temperature is higher than room temperature.

The reactive component is at least one of an acrylic component, a molecule having one or more vinyl ether substituents, or the reactive component is a water miscible component that is, after curing, capable of swelling upon exposure to water or to an alkaline or acidic water solution.

The reactive component may be an acrylic component. The acrylic component is an acrylic oligomer, an acrylic monomer, or a combination thereof.

Furthermore, in the present invention, the reactive component comprises at least one water miscible component that is, after curing, capable of swelling upon exposure to water or to an alkaline or acidic water solution. The water miscible component is preferably an acrylated urethane oligomer derivative of polyethylene glycol, a partially acrylated polyol oligomer, an acrylated oligomer having hydrophilic substituents, or any combination thereof. The hydrophilic substituents are preferably acidic substituents, amino substituents, hydroxy substituents, or any combination thereof.

Furthermore, the reactive component may comprise a molecule having one or more vinyl ether substituents.

Furthermore, in accordance with an embodiment of the present invention, the non-reactive component is polyethylene glycol, methoxy polyethylene glycol, glycerol, ethoxylated polyol, or propylene glycol.

Furthermore, in accordance with an embodiment of the present invention, the photo-initiator is a free radical photo-initiator, a cationic photo-initiator, or a combination thereof.

Furthermore, the first viscosity of the composition may be greater than 80 cps, between 80 and 300 cps. or around 200 cps.

Furthermore, the second viscosity of the composition is lower than 20 cps at a second temperature, which is greater than 60°C. Preferably, the second viscosity is between 8 and 15 cps at the second temperature, which is greater than 60°C. The second viscosity may be about 11 cps at a temperature around 85°C.

The composition may be used in a method for preparation of a 3-D object by 3-D printing.

The method may comprise dispensing a first interface material from a printing head, the first interface material comprising at least one reactive component; at least one photo-initiator; at least one surface-active agent; and at least one stabilizer; dispensing a second interface material from said printing head, the second interface material comprising at least one non-reactive and low toxicity compound; at least one surface-active agent; and at least one stabilizer; combining the first interface material and the second interface material in pre-determined proportions to produce construction layers for forming the 3-D object.

The reactive component of the first interface material may be an acrylic component, a molecule having one or more epoxy substituents, a molecule having one or more vinyl ether substituents, vinylpyrolidone, vinylcaprolactam, or any combination thereof.

The reactive component of the first interface material may comprise an acrylic component. The acrylic component is an acrylic monomer, an acrylic oligomer, an acrylic crosslinker, or any combination thereof.

The reactive component of the first interface material may comprise an acrylic component and in addition a molecule having one or more epoxy substituents, a molecule having one or more vinyl ether substituents, vinylcaprolactam, vinylpyrolidone, or any combination thereof.

The reactive component of the first interface material may comprise an acrylic component and vinylcaprolactam.

The reactive component of the first interface material may be a molecule having one or more vinyl ether substituents.

The reactive component of the first interface material may be a molecule having one or more epoxy substituents.

The reactive component of the first interface material may comprise a molecule having one or more epoxy substituents, and a molecule having one or more vinyl ether substituents.

The first interface material may further comprise at least one pigment and at least one dispersant. The pigment is a white pigment, an organic pigment, an inorganic pigment, a metal pigment or a combination thereof. The first interface material may further comprise a dye.

The method may further comprise the step of curing said first interface material.

The second interface material comprises one reactive component and one photo-initiator. The reactive component may be at least one of an acrylic component, a molecule having one or more vinyl ether substituents, or the reactive component is a water miscible component that is, after curing, capable of swelling upon exposure to water or to an alkaline or acidic water solution.

The reactive component may be an acrylic component. The acrylic component may be an acrylic oligomer, an acrylic monomer, or a combination thereof.

The reactive component may comprise at least one water miscible component that is, after curing, capable of swelling upon exposure to water or to an alkaline or acidic water solution. The water miscible component is preferably an acrylated urethane oligomer derivative of polyethylene glycol, a partially acrylated polyol oligomer, an acrylated oligomer having hydrophilic substituents, or any combination thereof. The hydrophilic substituents are preferably acidic substituents, amino substituents, hydroxy substituents, or any combination thereof.

The reactive component of the second interface material may comprise a molecule having one or more vinyl ether substituents.

The non-reactive component may be polyethylene glycol, methoxy polyethylene glycol, glycerol, ethoxylated polyol, or propylene glycol.

The photo-initiator of the first interface material and optionally of the second interface material may be a free radical photo-initiator, a cationic photo-initiator or any combination thereof.

The method may further comprise the step of curing the second interface material.

The first interface material and the second interface material may have a different modulus of elasticity and a different strength. The first interface material may have a higher modulus of elasticity and a higher strength than the second interface material.

The method may further comprise the step of forming a multiplicity of support layers for supporting the object. The support layers may be formed by combining the first interface material and the second interface material in pre-determined proportions. The support layers may have the same modulus of elasticity and the same strength as the construction layers. The support layers may have a lower modulus of elasticity and a lower strength than the construction layers.

The method may further comprise the step of combining the first interface material and the second interface material in pre-determined proportions to form a multiplicity of release layers for releasing the support layers from the object. The release layers may have a lower modulus of elasticity and a lower strength than the construction layers and the support layers.

The first interface material and said second interface material each have a first viscosity at room temperature, and a second viscosity compatible with ink-jet printers at a second temperature, which may be the same or different, wherein said second temperature is higher than room temperature.

### BRIEF DESCRIPTION OF THE DRAWINGS

The present invention will be understood and appreciated more fully from the following detailed description taken in conjunction with the appended drawings in which:
Fig. 1 is a schematic illustration of an embodiment of a 3-D printing system, described in US Patent No: 6,658,314, assigned to the Assignees of the present application; and
Fig. 2 is an elevational view of a 3-D object, constructed in accordance with an embodiment of the present invention.

### DETAILED DESCRIPTION OF THE PRESENT INVENTION

The present invention relates to compositions for use in the manufacture of 3-D objects, and to compositions for use as a support and/release material in the manufacture of 3-D objects. In the present specification there is also described a method for the preparation of a 3-D object by 3-D printing, using the above-mentioned compositions, and to a 3-D object obtained by said method.

The composition for use in the manufacture of the 3-D objects comprises at least one reactive component, at least one photo-initiator, at least one surface-active agent and at least one stabilizer. The composition is formulated so as to be compatible for use with ink-jet printers and to have a viscosity at room temperature above 50 cps.

The composition for use as a support and/or second interface material in the manufacture of the 3-D objects comprises at least one non-reactive and low-toxicity component, at least one surface-active agent and at least one stabilizer. The composition may further contain at least one reactive component and at least one photo-initiator. The composition is formulated so as to be compatible for use with ink-jet printers and to have a viscosity at room temperature above 50 cps.

The compositions will be described in further detail below.

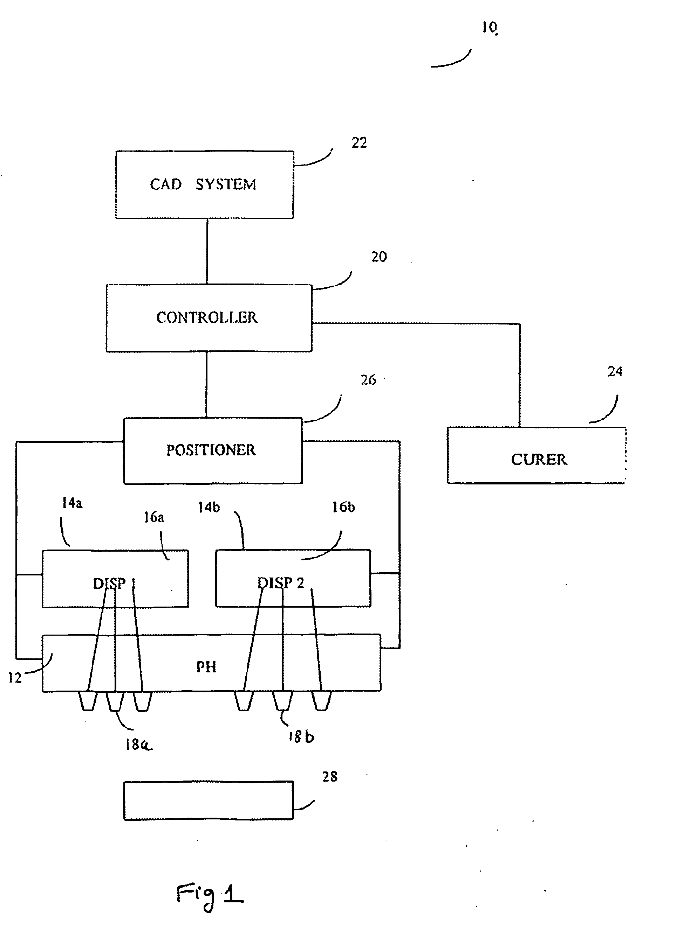

The 3-D object of the present invention can be built using a 3-D printing system similar to the one described in US Patent No. 6,658,314, assigned to the Assignees of the present application. The 3-D printing system is shown in Fig 1, to which reference is now made. Fig 1 is an illustration of a 3-D printing system, generally designated 10, which includes one or more printing heads, referenced 12, and at least two dispensers generally referenced 14 and individually referenced 14a and 14b, containing interface material, generally referenced 16 and individually referenced 16a and 16b, respectively.

Printing head 12 has a plurality of ink-jet type nozzles 18, through which interface materials 16a and 16b are jetted. In one embodiment, first dispenser 14a is connected to a first set of nozzles, referenced 18a, and second dispenser 14b is connected to a second set of nozzles, referenced 18b. Thus first interface material 16a is jetted through nuzzles 18a, and second interface material 16b is jetted through nozzles 18b. Alternatively, in another embodiment (not shown), the 3-D printing system may comprise at least two printing heads. The first printing head is connected to first dispenser 14a and is used to jet first interface material 16a; and the second printing head is connected to second dispenser 14b is used to jet second interface material 16b.

The 3-D printing system 10 further includes a controlled 20, a Computer Aided Design (CAD) system 22, curing unit 24, and optionally a positioning apparatus 26. The controller 20 is coupled to the CAD system 22, curing unit 24, positioning apparatus 26, printing head 12 and each of the dispensers 14.

The 3-D object being produced (28) is built in layers, the depth of each layer being controllable by selectively adjusting the output from each of the ink-jet nozzles 18.

By combining or mixing materials from each of the dispensers, wherein each dispenser contains interface material having a different hardness, it is possible to adjust and control the hardness of the material forming the 3-D object being produced. Thus, by combining the interface material being output from each of the dispensers, different parts of the 3-D object having a different modulus of elasticity and a different strength can be produced.

As used hereinafter, the term "strength" is used as a relative term to indicate the difference in modulus of elasticity among interface materials. The strength of a material may be described by reference to its modulus of elasticity, which may be defined as: "the ratio of stress to its corresponding strain under given conditions of load, for materials that deform elastically, according to Hooke's law".

The first dispenser 14a contains a first interface material 16a, referred to hereinafter as the "first interface material", and the second dispenser 14b contains a second interface material 16b, referred to hereinafter as the "second interface material". The first interface material has a different (harder) modulus of elasticity and a greater strength than the second interface material. By combining the first interface material and the second interface material, different layers of the 3-D object having a different modulus of elasticity and a different strength can be produced, such as, for example, a construction layer, a support layer and a release layer, as defined hereinbelow.

For example, combining the first interface material and the second interface material forms a multiplicity of construction layers, which are defined as the layers constituting the 3-D object. Multiplicity, as used hereinafter, refers to a number which is one or greater.

Further, combining the first interface material and the second interface material forms a multiplicity of support layers, which are defined as the layers supporting the 3-D object, and not constituting the 3-D object.

Further, combining the first interface material and the second interface material forms a multiplicity of release layers, which are defined as the layers (not constituting the 3-D object) for separating the 3-D object layer from layers such as the support layers. The release layers have a lower modulus of elasticity and a lower strength than the construction layers and the support layers.

In one case, the support layers are designed exactly as the construction layers, and thus have the same modulus of elasticity and the same strength as the construction layers. In this way, the construction layers form a core, and the support layers look like the negative printing of the core. The release layers are positioned between the construction layers and the support layers, and are used to separate the construction layers from the support layers.

In another case, the support layers have a lower modulus of elasticity and a lower strength than the construction layers. The support layers may be separated from the construction layers by taking advantage of their weaker properties, as will be explained in detail below. Alternatively, the support layers may be separated from the construction layers by positioning release layers between the construction layers and the support layers.

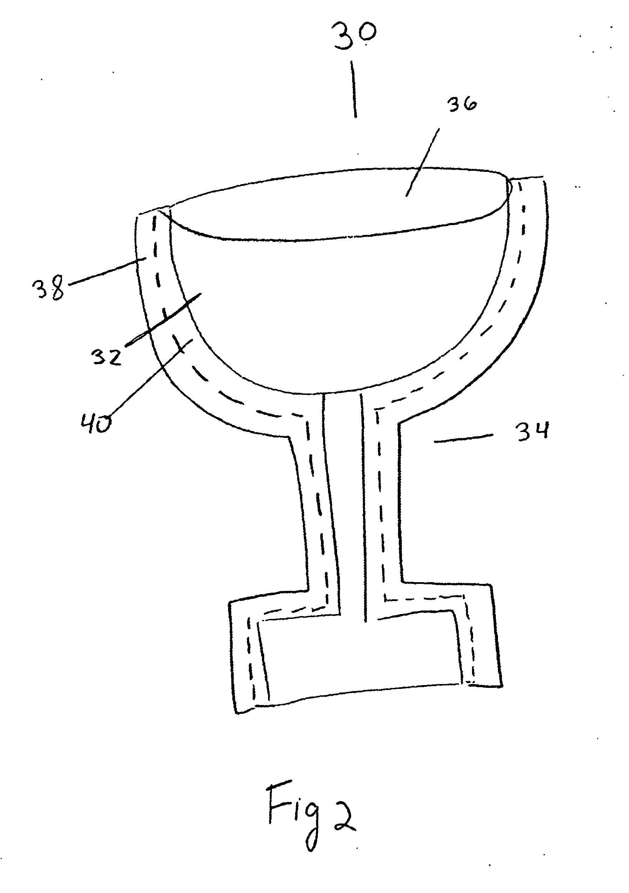

In order to more clearly define the present invention, reference is now made to Fig 2, which is a 3-D model of a wineglass, generally referenced 30. This 3-D model is printed using the ink-jet type printing system of Fig 1. Combining the first interface material and the second interface material form a multiplicity of construction layers 32 which make up wine glass 30.

The construction layers 32 of wineglass 30 need to be supported externally, such as in the area referenced 34. Furthermore, an internal void, referenced 36, needs to be formed during printing. Thus a multiplicity of support layers 38, formed by combining the first interface material and the second interface material, are printed.

Furthermore, combination of the first interface material and the second interface material forms a multiplicity of release layers 40. In one embodiment, release layers 40 are positioned between construction layers 32 and support layers 38. Generally, release layers 40 have a different (lower) modulus of elasticity than support layers 38 and construction layers 32. Thus release layers 40 can be used to separate support layers 38 from construction layers 32.

The present invention, which will now be described in detail, provides compositions suitable for use as the second interface material.

The first interface material and second interface material are especially designed and formulated for building a 3-D object using 3-D printing. Accordingly, the first and the second interface material are designed to have increased viscosity at room temperature, which is defined as about 20-30°C. Preferably, the first and second interface material have a viscosity greater than 50 cps at room temperature, more preferably between 80 and 300 cps. In a preferred embodiment, the first and the second interface material have a viscosity of around 300 cps at room temperature,

Further, the first interface material and the second interface material have a second viscosity compatible with ink-jet printing, at a second temperature which is higher than room temperature. A composition compatible with ink-jet printing has low viscosity, preferably below 20 cps at the printing temperature, in order to function properly in the printing process. The first interface material and the second interface material, upon heating, have a viscosity preferably below 20 cps, enabling the construction of the 3-D object under heat. The temperature typically used to build the 3-D model of the present invention is higher than 60°C, preferably about 85°C. In one embodiment, the first and second interface materials have a viscosity of 8-15 cps at a temperature greater than 60°C. In another embodiment, the first and second interface materials have a viscosity of 11 cps at a temperature of about 85°C.

Having this viscosity, the first and second interface material are distinguished from prior art formulations designed for ink-jet printing, which have low viscosity at room temperature, the temperature at which the printing is conducted. High viscosity at room temperature is a desirable property for 3-D objects, a feature that is lacking in the prior art formulations.

### FIRST INTERFACE MATERIAL (not claimed in the present invention)

The first interface material is formulated to give, after curing, a solid material with mechanical properties that permit the building and handling of 3-D models. The first interface material comprises:
at least one reactive component;
at least one photo-initiator;
at least one surface-active agent; and
at least one stabilizer.

In one example, the reactive component is an acrylic component, a molecule having one or more epoxy substituents, a molecule having one or more vinyl ether substituents, vinylpyrolidone, vinylcaprolactam, or any combination thereof. The acrylic component is an acrylic monomer, an acrylic oligomer, an acrylic crosslinker, or any combination thereof.

An acrylic monomer is a monofunctional acrylated molecule which can be, for example, esters of acrylic acid and methacrylic acid. An example of an acrylic monomer for the present invention is phenoxyethyl acrylate, marketed by Sartomer under the trade name SR-339. Another example of an acrylic monomer is marketed by Sartomer under trade name SR-9003.

An acrylic oligomer is a polyfunctional acrylated molecule which can be for example polyesters of acrylic acid and methacrylic acid and a polyhydric alcohol, such as polyacrylates and polymethacrylates of trimethylolpropane, pentaerythritol, ethylene glycol, propylene glycol and the like. Examples of acrylic oligomers are the classes of urethane acrylates and urethane methacrylates. Urethane-acrylates are manufactured from aliphatic or cycloaliphatic diisocyanates or polyisocyanates and hydroxyl-containing acrylic acid esters. An example is a urethane-acrylate oligomer marketed by Cognis under the trade name Photomer-6010.

An acrylic crosslinker is a molecule which provides enhanced crosslinking. Examples of such resins are 1,4-butanediol diacrylate, 1,4-butanediol dimethacrylate, 1,6-hexamethylene glycol diacrylate, neopentyl glycol dimethacrylate, trimethylol propane trimethacrylate, pentaerythritol triacrylate, penta-erythritol trimethacrylate triethylene glycol triacrylate, triethylene glycol trimethacrylate, and the like. An example of an acrylic crosslinker for the present invention is trimethylol propane triacrylate, marketed by Sartomer under the trade name SR-351. Another example of a crosslinker is UVM-45, marketed by CRODA.

The reactive component in the first interface material can also be a molecule having one or more vinyl ether substituents. Conventional vinyl ether monomers and oligomers which have at least vinyl ether group are suitable. Examples of vinyl ethers are ethyl vinyl ether, propyl vinyl ether, isobutyl vinyl ether, cyclohexyl vinyl ether, 2-ethylhexyl vinyl ether, butyl vinyl ether, ethyleneglocol monovinyl ether, diethyleneglycol divinyl ether, butane diol divinyl ether, hexane diol divinyl ether, cyclohexane dimethanol monovinyl ether and the like. An example of a vinyl ether for the present invention is 1,4 cyclohexane dimethanol divinyl ether, marketed by ISP under the trade name CHVE.

The reactive component in the first interface material can also be a molecule having one or more epoxy substituents. Conventional epoxy monomers and oligomers which have at least one oxirane moiety are preferred. Suitable epoxy containing molecules are displayed in Table 1 below:

**Table 1: Examples of epoxy-contatning reactive component**

| Trade Name | Type of Material | Supplier |
|---|---|---|
| ERL-4299 or UVR-6128 | Bis-(3,4 cyclohexylmethyl) adipate | Union Carbide |
| UVR-6105 and UVR-6110 | 3,4-epoxy cyclohexylmethyl-3,4-epoxycyclohexyl carboxylate | Union Carbide |
| D.E.R 732 | Aliphatic epoxy, Polyglycol diglycidyl ether | Dow chemicals |
| Vinylcyclohexene Monoxide | 1,2 epoxy-4-vinylcyclohexane | Union Carbide |
| D.E.N. 431 | Epoxy novolac resin | Dow corning |
| UVR-6216 | 1,2-epoxy hexadecane | Union Carbide |
| UVI-6100 | Cycloaliphatic epoxide diluent | Union Carbide |
| Vikoflex 7170 | Fullyl epoxidized soy bean oil | Elf Atochem, INC. |
| ERL-4221D | 3,4-epoxy cyclohexylmethyl 3,4-epoxy cyclohexane carboxylate | Union Carbide |

The reactive component of the first interface material can comprise any combination of an acrylic component as defined hereinabove, a molecule having one or more epoxy substituents as defined hereinabove, a molecule having one or more vinyl ether substituents as defined hereinabove, vinylcaprolactam and vinylpyrolidone.

In one example, the reactive component of the first interface material comprises an acrylic monomer, an acrylic oligomer, an acrylic crosslinker and vinylcaprolactam. In another example, the reactive component comprises an acrylic component as defined hereinabove and a molecule having one or more epoxy substituents as defined hereinabove. In another example, the reactive component of the first interface material comprises an acrylic component as defined hereinabove and a molecule having one or more vinyl ether substituents as defined hereinabove. In another example, the reactive component in the first interface material comprises a molecule having one or more vinyl ether substituents as defined hereinabove, and a molecule having one or more epoxy substituents as defined hereinabove.

The photo-initiator of the first interface material and of the second interface material may be the same or different, and is a free radical photo-initiator, a cationic photo-initiator, or any combination thereof.

The free radical photo-initiator can be any compound that produces a free radical on exposure to radiation such as ultraviolet or visible radiation and thereby initiates a polymerization reaction. Examples of some suitable photo-initiators include benzophenones (aromatic ketones) such as benzophenone, methyl benzophenone, Michler's ketone and xanthones; acylphosphine oxide type photo-initiators such as 2,4,6-trimethylbenzolydiphenyl phosphine oxide (TMPO), 2,4,6-trimethylbenzoylethoxyphenyl phosphine oxide (TEPO), and bisacylphosphine oxides (BAPO's); benzoins and bezoin alkyl ethers such as benzoin, benzoin methyl ether and benzoin isopropyl ether and the like. Examples of photo-initiators are alpha-amino ketone, marketed by Ciba Specialties Chemicals Inc. (Ciba) under the trade name lrgacure 907, and bisacylphosphine oxide (BAPO's), marketed by Ciba under the trade name I-819.

The free-radical photo-initiator can be used alone or in combination with a co-initiator. Co-initiators are used with initiators that need a second molecule to produce a radical that is active in the UV-systems. Benzophenone is an example of a photoinitiator that requires a second molecule, such as an amine, to produce a reactive radical. After absorbing radiation, benzophenone reacts with a ternary amine by hydrogen abstraction, to generate an alpha-amino radical which initiates polymerization of acrylates. An example of a class of co-initiators are alkanolamines such as triethylamine, methyldiethanolamine and triethanolamine.

Suitable cationic photo-initiators include compounds which form aprotic acids or Bronstead acids upon exposure to ultraviolet and/or visible light sufficient to initiate polymerization. The photo-initiator used may be a single compound, a mixture of two or more active compounds, or a combination of two or more different compounds, i.e. co-initiators. Examples of suitable cationic photo-initiators are aryldiazonium salts, diaryliodonium salts, triarylsulphonium salts, triarylselenonium salts and the like. A preferred cationic photo-initiator for the present invention is a mixture of triarylsolfonium hexafluoroantimonate salts marketed by Union Carbide as UVI-6974.

Other components of the first interface material and the second interface material are surface-active agents and inhibitors (thermal stabilizers). A surface-active agent is used to reduce the surface tension of the formulation to the value required for jetting, which is typically around 30 dyne/cm. An example of a surface-active agent for the present invention is silicone surface additive, marketed by Byk Chemie under the trade name Byk 307. Inhibitors are employed in the formulations of the first interface material and the second interface material to permit the use of the formulation at high temperature, preferably around 85C, without causing thermal polymerization.

In one example, the first interface material further comprises at least one pigment and at least one dispersant. The pigment is a white pigment, an organic pigment, an inorganic pigment, a metal pigment or a combination thereof. An example of a white pigment for the present invention is organic treated titanium dioxide, marketed by Kemira Pigments under the trade name UV TITAN M160 VEG. An example of an organic pigment for the present invention is an organic pigment marketed by Elementis Specialties under the trade name Tint Aid PC 9703. Examples of dispersants for the present invention are dispersants comprising a copolymer with acidic groups marketed by Byk Chemie under the trade name Disperbyk 110, and a dispersant comprising a high molecular weight block copolymer with pigment affinic groups, marketed by Byk Chemie under the trade name Disperbyk 163.

Furthermore, combinations of white pigments and dyes may be used to prepare colored resins. In such combinations, the white pigment has a double task: 1) to impart opacity; and 2) to shield the dye from UV radiation, to prevent bleaching of the resin. Thus, the first interface material may further comprise a dye. The dye is chosen so as not to interfere with the curing efficiency of the formulation of the first interface material. The dye may be any of a broad class of solvent soluble dyes. Some examples are azo dyes which are yellow, orange, brown and red; anthraquinone and triarylmethane dyes which are green and blue; and azine dye which is black. An example of a dye for the present invention is Solvent Red 127, marketed by Spectra Colors Corp. under the trade name Spectrasol RED BLG.

The relative proportions of the different components of the first interface material can vary. In one embodiment, the first interface material comprises the following components: 50% acrylic oligomer(s), 30% acrylic monomer(s), 15% acrylic crosslinker, 2% photoinitiator, surface active agent, pigments, dispersants; and stabilizers.

Examples of preferred formulations of the first interface material are provided hereinbelow in Tables 2-4, to which reference is now made. Tables 2 and 3 illustrate examples of possible formulations of the first interface material. Table 4 illustrates examples of colored formulations, which comprise pigments, dispersants and dyes, as defined hereinabove. To any of the examples in Tables 2 and 3 may be added the combination of the colorants of Table 4.

**Table 2: Example of Characteristic Formulation Components of First Interface Material**

| # | Trade Name | Chemical Type | Function the formulation | Supplier |
|---|---|---|---|---|
| A | Photomer-6010 | Urethane Acrylate Oligomer | Oligomer | Cognis |
| B | SR-339 | Phenoxy ethyl Acrylate | monomer | Sartomer |
| C | SR -351 | Trimethylol propane triacrylate | Cross-linker | Sartomer |
| D | Irgacure 907 | alpha-Amino Ketone | Free radical photo-initiator | Ciba Specialties Chemical Inc. |
| E | BP | Benzophenone | Free radical photo-initiator | Satomer |
| F | Triethanol Amine | Ternary Amine | Free radical Coinitiator | Sigma |
| G | Byk 307 | Silicone Surface Additive | Surface agent | Byk Chemie |
| H | MEHQ | 4-Methoxy phenol | Inhibitor | Sigma |
| I | Cyracure UVR-6110 | 3,4 Epoxycyclohexylmethyl-3,4-epoxycyclohexylcarboxylate | Epoxy oligomer | Union Carbide |
| J | UVI-6974 | Mixed Triarylsulfonium Hexafluoroantimonate Salts | Cationic photo-initiator | Union Carbide |
| K | CHVE | 1,4-cydohexane dimethanol divinyl ether | Vinyl Ether Monomer | ISP |
| L | UV TITAN M160 VEG | Organic Treated Titanium Dioxide | White pigment | KEMIRA PIGMENT S |
| M | Disperbyk 110 | Copolimer with acidic groups | Pigment Dispersant | Byk Chemie |
| N | Spectrasol RED BLG | Solvent Red 127 | Dye | Spectra Colors Corp. |
| O | Tint Aid PC 9703 | Organic pigment | Organic pigment | Elementis Specialties |
| P | Disperbyk 163 | High molecular weight block copolymer with pigment affinic groups | Pigment Dispersant | Byk Chemie |
| Q | V-Cap | Vinylcaprolactam | Monomer | ISP |
| R | V-Pyrol | Vinylpyrolidone | Monomer | ISP |

**Table 3: Examples of Possible Formulation Compositions of First Interface Material**

| Example | A | B | C | D | E | F | G | H | I | J | K | Q | R |
|---|---|---|---|---|---|---|---|---|---|---|---|---|---|
| 1 | X | X | X | X | | | X | X | | | | | |
| 2 | X | X | | X | | | X | X | | | | | |
| 3 | X | | X | X | | | X | X | | | | | |
| 4 | | X | X | X | | | X | X | | | | | |
| 5 | X | X | X | | X | X | X | X | | | | | |
| 6 | X | X | | | X | X | X | X | | | | | |
| 7 | X | | X | | X | X | X | X | | | | | |
| 8 | | X | X | | X | X | X | X | | | | | |
| 9 | X | | X | X | | | X | X | | | X | | |
| 10 | X | | X | | X | X | X | X | | | X | | |
| 11 | | | | | | | X | X | X | X | X | | |
| 12 | | X | X | X | | | X | X | X | X | | | |
| 13 | X | X | X | X | X | X | X | X | X | X | X | | |
| 14 | X | X | X | X | | | X | X | | | | X | |
| 15 | X | X | X | X | | | X | X | | | | | X |

**Table 4: Examples of colored formulations of first interface material**

| Example | L | M | N | O | P |
|---|---|---|---|---|---|
| 16 | X | X | | | |
| 17 | X | X | X | | |
| 18 | X | X | | X | X |
| 19 | | | | X | X |
| 20 | | | X | X | X |

A particularly preferred formulation of the first interface material is presented in entry No. 14 of Table No. 3. According to this particularly preferred example, the first interface material comprises
an acrylic oligomer, which can be any acrylic oligomer as defined hereinabove, and which is preferably a urethane acrylate oligomer,
an acrylic monomer, which can be any acrylic monomer as defined hereinabove, and which is preferably phenoxy ethyl acrylate;
an acrylic crosslinker, which can be any acrylic crosslinker as defined hereinabove, and which is preferably trimethylol propane triacrylate;
a radical photo-initiator, which can be any radical photo-initiator as defined hereinabove, and which is preferably alpha-amino ketone;
a surface agent, which is preferably a silicone surface additive:
an inhibitor, which is preferably 4-methoxyphenol; and
vinylcaprolactam.

### SECOND INTERFACE MATERIAL

The second interface material is formulated to form a release layer to permit a manual easy cleaning of the 3-D model from its support. The second interface material may be one of two different principle kinds: 1) a liquid material lacking any curable groups that remains liquid even after curing. In one embodiment, the liquid is water miscible and is easily washed out by water; and 2) a solid material that is formulated as a very weak curable material that, when cured, is capable of swelling in water or in alkaline or acidic water. Thus, when cured, the second interface material swells and almost breaks upon exposure to water, with minimum manual work required. In both cases the second interface material is formulated so as to permit fast, easy and efficient removal of the second interface material and cleaning of the 3-D model from its support.

The second interface material of the present invention comprises:
a composition suitable for support in building a three dimensional object by a method of selective dispensing, said composition comprising:
   a reactive component, the reactive component comprises a water-miscible component that after curing is capable of swelling upon exposure to water, alkaline water solution or an acidic water solution;
   a photo-initiator;
   a non-reactive and low toxicity component;
   a surface active agent for reducing surface tension to around 30 mN/m (30 dyne/cm), and
   a stabilizer;
   wherein said composition has a viscosity above 50 mPas (50 cps) at room temperature and a viscosity lower than 20 mPas (20 cps) at a temperature higher than 60°C.

The non-reactive component of the second interface material is a non-reactive and low toxicity compound, preferably a water miscible one. The non-reactive component is chosen to enhance the water-swelling rate, and to reduce the mechanical strength of the second interface material. High water diffusion rate is desirable in order to minimize the time needed for the water cleaning process of the 3-D model. Examples of non-reactive components for the present invention are polyethylene glycol marketed by Aldrich under the trade name PEG 400, methoxypolyethylene glycol marketed by Aldrich under the trade name methoxycarbowax 500 and 1000, and propylene glycol. Other examples are ethoxylated polyols and glycerol.

The second interface material is formulated as a curable composition that is capable of solidifying upon curing. The reactive components may be similar to those used in the first interface material, but are chosen specifically to give a hydrophillic cured resin, with very weak mechanical properties. Thus, upon curing, a solid composition is formed that is very weak and can be easily pulverized by hand or using water.

The reactive component is at least one of an acrylic component, a molecule having one or more vinyl ether substituents, or a water miscible component that is, after curing, capable of sweating upon exposure to water or to an alkaline or acidic water solution.

The acrylic component is an acrylic monomer or an acrylic oligomer, and may be any one of the examples defined hereinabove. Examples of acrylic components for use in the second interface material of the present invention are polyethylene glycol monoacrylate, marketed by Laporte under the trade name Bisomer PEA6, and polyethylene glycol diacrylate, marketed by Sartomer under the trade name SR-610, methoxypolyethyleneglycole 550 monomethacrylate, and the like.

The reactive component of the second interface material can also be a water miscible component that is, after curing, capable of swelling upon exposure to water or to an alkaline or acidic water solution. Examples of water miscible components for the present invention are an acrylated urethane oligomer derivative of polyethylene glycol - polyethylene glycol urethane diacrylate, a partially acrylated polyol oligomer, an acrylated oligomer having hydrophillic substituents, or any combination thereof. The hydrophilic substituents are acidic substituents, amino substituents, hydroxy substituents, or any combination thereof. An example of an acrylated monomer with hydrophillic substituents is betha-carboxyethyl acrylate, which contains acidic substituents.

The reactive component of the second interface material can also be a molecule having one or more vinyl ether substituents, which may be any of the compounds as defined hereinabove. An example of vinyl ether for the second interface material is 1,4-cyclohexane dimethanol divinyl ether, marketed by ISP under the trade name CHVE.

The reactive component of the second interface material may be an acrylic oligomer. The reactive component of the second interface material may be a combination of an acrylic component as defined hereinabove and a water miscible component as defined hereinabove. In another embodiment, the reactive component of the present invention is a combination of an acrylic component as defined hereinabove and a molecule having one or more vinyl ether substituents, as defined hereinabove. The reactive component may be a combination of a water miscible component as defined hereinabove, and a molecule having one or more vinyl ether substituents, as defined hereinabove.

The photo-initiator can be any photo-initiator, as defined above.

Besides swelling, another characteristic of the solid support upon exposure to water or to an alkaline or acidic water solution may be the ability to break down during exposure to water or to an alkaline or acidic water solution. Because the second interface material is made of hydrophillic components, during the swelling process, internal forces appear and cause fractures and breakdown of the cured second interface material.

In addition, the second interface material may be at least partially water-soluble. At least part of the second interface material is completely water soluble/miscible. During the removal of the support and/or release layers, the water soluble/miscible components are extracted out with water.

In addition, in one embodiment, the second interface material liberates bubbles upon exposure to water or to an alkaline water or acidic water solution. The bubbles are intended to help in the process of removal of the support and/or release layers from the construction layers.

In one embodiment, the bubbles may be liberated by a bubble releasing substance (BRS) that is present in the water solution that is used to clean out the 3-D object. Such a substance may be a carbonate or bicarbonate, for example sodium bicarbonate (SBC). During the swelling process, at least part of the SBC is introduced or absorbed into the second interface material, where it is transformed into carbon dioxide gas (CO2) and a water-soluble salt. The trigger for the production of CO2 may be the reaction of the SBC with an acid functionality present in the second interface material. Such acid functionality may be introduced as part of the second interface material formulation or introduced later, after curing, using an acid water solution. For example, the first step may be to put the 3-D object with its support in a water solution containing a SBC, then to place the same object in an acidic solution. The acid will start to decompose the SBC and product gas (bubbles),

In another embodiment, the substance that liberates gas is already present in the formulation of the second interface material. For example, the second interface material may contain calcium carbonate as a solid pigment. In that case, the trigger is the introduction of the second interface material in a water or acidic solution.

It should be clear that a BRS is not limited to a sodium bicarbonate or calcium carbonate and an acidic water solution. Other chemical reagents and reactions may be used to achieve the same result - the production of bubbles inside the matrix of the second interface material. For example, the SBC may be any alkaline metal or alkaline earth metal carbonate or bicarbonate.

Examples of preferred formulations of the second interface material are provided hereinbelow in Table 5 and Table 6, to which reference is now made. Tables 5 and 6 display various formulations that are suitable for use as the second interface material.

**Table 5: Examples of Characteristic Formulation Components of Second Interface Material**

| # | Trade Name | Chemical Type | Function in the formulation | Supplier |
|---|---|---|---|---|
| A | SR-610 | Polyethylene Glycole (600) Diacrylate | Oligomer | Sartomer |
| B | Bisomer PEA6 | Polyethylene Glycole monoacrylate | Water swelling/ sensitive Oligomer | Laport |
| C | PEG 400 | Polyethylene Glycole 400 | Polymer (hydrophilic and palsticizer) | Aldrich |
| D | Irgacure 907 | alpha-Amino Ketone | Free radical photo-initiator Type I | Ciba Specialties Chemical Inc. |
| E | BP | Benzophenone | Free radical photo-initiator Type II | Satomer |
| F | Triethanol Amine | Ternary Amine | Free radical Coinitiator for Type II photo-initiator | Aldrich |
| G | Byk 307 | Silicone Surface Additive | Surface agent | Byk Chemie |
| H | MEHQ | 4-Methoxy phenol | Inhibitor (thermal stabilizer) | Sigma |
| I | PEG UA | Polyethylene glycol urethane diacrylate | Water swelling/sensiti ve oligomer | Home made |
| J | AP | Partially acrylated polyol | Water swelling/ sensitive oligomer | Home made |
| K | Betha-CEA | Betha-caboxyethyl acrylate | Acidic monomer | |
| M | CHVE | 1,4-Cyclohexane dimethanol divinyl ether | Vinyl ether monomer | ISP |
| N | Tone polyol 0301 | Caprolactone polyol | Polyol (plasticizer) | Union Cabide |
| P | methoxycarbo wax 500 and 1000 | methoxypolyethylene glycol | Polymer (hydrophilic and palsticizer) | |

**Table 6: Examples of Possible Formulation Compositions of Second Interface Material**

| Example | A | B | C | D | E | F | G | H | I | J | K | L | M | N |
|---|---|---|---|---|---|---|---|---|---|---|---|---|---|---|
| 1 | X | | X | X | | | X | X | | | | | | |
| 2 | X | | X | | X | X | X | X | | | | | | |
| 3 | | X | X | X | | | X | X | | | | | | |
| 4 | | X | X | | X | X | X | X | | | | | | |
| 5 | X | X | X | X | | | X | X | | | | | | |
| 6 | X | X | X | | X | X | X | X | | | | | | |
| 7 | | | X | | | | X | X | X | | | | | |
| 8 | | | X | X | | | X | X | | X | | | | |
| 9 | | X | X | X | | | X | X | | | X | | | |
| 10 | | | X | X | | | X | X | | | | X | | |
| 11 | | | X | X | | | X | X | | | | | | |
| 12 | X | | | X | | | X | X | | | | X | X | |
| 13 | | X | | X | | | X | X | | X | | | | X |
| 14 | | X | X | X | X | X | X | X | | X | X | | | X |

A particularly preferred formulation of the second interface material is presented in entry No. 3 of Table 6. According to this particularly preferred embodiment of the present invention, the second interface material comprises;
a water swelling oligomer, which can be any water swelling oligomer as defined hereinabove, and which is preferably polyethylene glycole monoacrylate;
a non-reactive component, which can be any non-reactive component as defined hereinabove, and which is preferably polyethylene glycole;
a radical photo-initiator, which can be any radical photo-initiator as defined hereinabove, and which is preferably alpha-amino ketone;
a surface agent, which is preferably a silicone surface additive; and
an inhibitor, which is preferably 4-methoxyphenol.

Another particularly preferred formulation of the second interface material is presented in entry No. 4 of Table 6. According to this particularly preferred embodiment of the present invention, the second interface material comprises:
a water swelling oligomer, which can be any water swelling oligomer as defined hereinabove, and which is preferably polyethylene glycole monoacrylate;
a non-reactive component, which can be any non-reactive component as defined hereinabove, and which is preferably polyethylene glycole;
a radical photo-initiator, which can be any radical photo-initiator as defined hereinabove, and which is preferably benzophenone;
a co-initiator, which can be any co-initiator as defined hereinabove, and which is preferably triethanolamine;
a surface agent, which is preferably a silicone surface additive; and
an inhibitor, which is preferably 4-methoxyphenol.

The first interface material and the second interface material are suitable for use in the method for 3-D printing which is described in U.S. Patent 6,658,314, assigned to the Assignees of the present application and is incorporated herein by reference.

Briefly, the method comprises:
dispensing a first interface material from a printing head;
dispensing a second interface material from said printing head; and
combining the first interface material and the second interface material in pre-determined proportions to a produce a multiplicity of construction layers for forming the three-dimensional model.

The method may further comprise the step of curing the first interface material. Further, when the second interface material comprises a reactive component, the method may further comprise the step of curing the second interface material. Curing may be carried out as described in U.S. Patent 6,658,314. For example, the curing method is by radiation, such as Ultraviolet (UV) and/or Visible (Vis) and/or Infra Red (IR) and/or UV-Vis radiation. Preferably the curing method is UV-Vis radiation.

In operation, in order to obtain layers of different modulus of elasticity and a different strength, the first interface material and the second interface material are combined in pre-determined proportions. For example, in order to obtain layers having a higher modulus of elasticity and a higher strength such as the construction layers, a suitable combination that contains mostly the first interface material is used. Further, in order to obtain layers having a lower modulus of elasticity and a lower strength such as the release layers, a suitable combination that includes mostly the second interface material is used.

By way of example, in order to produce the construction layers and/or the support layers, a combination that includes 90-100% of the first interface material and 0-10% of the second interface material is used. Further, in order to produce the release layers, a combination that includes 0-10% of the first interface material and 90-100% of the second interface material is used. In another embodiment, in order to produce support layers that have a lower modulus of elasticity and a lower strength than the construction layers, a combination that includes 30-70% of the first interface material and 70-30% of the second interface material is used.

Thus a 3-D object is produced which is comprised of a core consisting of a multiplicity of construction layers. The construction layers are formed by combining predetermined proportions of the first interface material and the second interface material.

The 3-D object may further comprise a multiplicity of support layers for supporting the core. The support layers are prepared by combining pre-determined proportions of the first interface material and the second interface material. The support layers may be designed exactly like to construction layers, or may be designed to be weaker (lower modulus of elasticity) than the construction layers,

The 3-D object may further comprise a multiplicity of release layers for releasing the support layers from the construction layers. Preferably, the release layers are positioned between the support layers and the construction layers. The release layers are prepared by combining pre-determined proportions of the first interface material and the second interface material.

It will be appreciated by persons skilled in the art that the present invention is not limited by what has been particularly shown and described herein above and that numerous modifications, all of which fall within the scope of the present invention, exist. Rather, the scope of the invention is defined by the claims which follow:

## Claims

1. A composition suitable for support in building a three dimensional object by a method of selective dispensing, said composition comprising:
a reactive component, the reactive component comprises a water-miscible component that after curing is capable of swelling upon exposure to water, alkaline water solution or an acidic water solution;
a photo-initiator;
a non-reactive and low toxicity component;
a surface active agent for reducing surface tension to around 30 mN/m (30 dyne/cm), and
a stabilizer;
wherein said composition has a viscosity above 50 mPas (50 cps) at room temperature and a viscosity lower than 20 mPas (20 cps) at a temperature higher than 60°C.

2. The composition according to claim 1, wherein said water miscible component is an acrylated urethane oligomer derivative of polyethylene glycol, a partially acrylated polyol oligomer, an acrylated oligomer having hydrophilic substituents, or any combination thereof.

3. The composition according to claim 2, wherein said hydrophilic substituents are acidic substituents, amino substituents, hydroxy substituents, or any combination thereof.

4. The composition according to claim 1, wherein said photo-initiator is a free radical photo-initiator, a cationic photo-initiator, or any combination thereof.

5. The composition according to claim 1, wherein said non-reactive component is polyethylene glycol, methoxypolyethylene glycol, glycerol, ethoxylated polyol, or propylene glycol.

6. The composition according to claim 1, wherein the composition is a curable composition capable of solidifying upon curing.

7. The composition according to claim 1, further comprising a bubble releasing substance able to produce gas upon exposure to water solution, an alkaline water solution or acidic water solution.

8. The composition according to claim 7, wherein said bubble releasing substance is sodium bicarbonate, calcium carbonate or a combination thereof.

9. The composition according to claim 1, wherein upon curing, said composition is at least partially water soluble.

10. The composition according to claim 1, wherein upon curing, a solid material formulated as weak curable material capable of breaking upon exposure to water.

11. The composition according to claim 1, wherein upon curing a solid composition is formulated that can be easily pulverized by hand or using water.

12. A solid composition formed by curing the composition of any one of claims 1 to 11.

## Patentansprüche

1. Zusammensetzung, die sich zur Unterstützung beim Bau eines dreidimensionalen Objekts durch ein Verfahren der selektiven Abgabe eignet, wobei die genannte Zusammensetzung folgendes umfasst:
eine Reaktionskomponente, wobei die Reaktionskomponente eine wassermischbare Komponente umfasst, die nach dem Härten quellfähig ist, nachdem sie Wasser, einer alkalischen Wasserlösung oder einer acidischen Wasserlösung ausgesetzt worden ist;
einen Photoinitiator;
eine nicht-reaktionsfähige Komponente mit geringer Toxizität;
eine oberflächenaktive Substanz zum Reduzieren der Oberflächenspannung auf etwa 30 mN/m (30 Dyn/cm); und
einen Stabilisator;
wobei die genannte Zusammensetzung bei Raumtemperatur eine Viskosität von über 50 mPa (50 cps) aufweist, und wobei sie bei einer Temperatur von mehr als 60 °C eine Viskosität von unter 20 mPa (20 cps) aufweist.

2. Zusammensetzung nach Anspruch 1, wobei es sich bei der wassermischbaren Komponente um ein acryliertes Urethanoligomer-Derivat von Polyethylenglykol, ein teilweise acryliertes Polyololigomer, ein acryliertes Oligomer mit hydrophilen Substituenten oder eine beliebige Kombination dieser handelt.

3. Zusammensetzung nach Anspruch 2, wobei es ich bei den genannten hydrophilen Substituenten um acidische Substituente, Amino-Substituente, Hydroxy-Substituente oder jede beliebige Kombination dieser handelt.

4. Zusammensetzung nach Anspruch 1, wobei es sich bei dem genannten Photoinitiator um einen Photoinitiator für freie Radikale, einen kationischen Photoinitiator oder eine beliebige Kombination dieser handelt.

5. Zusammensetzung nach Anspruch 1, wobei es sich bei der genannten nichtreaktionsfähigen Komponente um Polyethylenglykol, Methoxypolyethylenglykol, Glycerol, ethoxyliertes Polyol oder Propylenglykol handelt.

6. Zusammensetzung nach Anspruch 1, wobei es sich bei der Zusammensetzung um eine härtbare Zusammensetzung handelt, die sich nach dem Härten verfestigen kann.

7. Zusammensetzung nach Anspruch 1, wobei diese ferner eine Blasen freisetzende Substanz umfasst, die Gas erzeugen kann, wenn sie einer Wasserlösung, einer alkalischen Wasserlösung oder einer acidischen Wasserlösung ausgesetzt wird.

8. Zusammensetzung nach Anspruch 7, wobei es sich bei der genannten Blasen freisetzenden Substanz um ein Natriumbicarbonat, ein Kalziumbicarbonat oder eine Kombination dieser handelt.

9. Zusammensetzung nach Anspruch 1, wobei nach dem Härten die genannte Zusammensetzung zumindest teilweise wasserlöslich ist.

10. Zusammensetzung nach Anspruch 1, wobei nach dem Härten ein festes Material als ein schwaches, härtbares Material gebildet wird, das zerbrechen kann, wenn es Wasser ausgesetzt wird.

11. Zusammensetzung nach Anspruch 1, wobei nach dem Härten eine feste Zusammensetzung gebildet wird, die per Hand oder unter Verwendung von Wasser leicht pulverisiert werden kann.

12. Feste Zusammensetzung, die durch Härten der Zusammensetzung nach einem der Ansprüche 1 bis 11 gebildet wird.

## Revendications

1. Composition appropriée pour aider à construire un objet tridimensionnel par un procédé d'administration sélective, ladite composition comprenant :
un composant réactif, le composant réactif comprenant un composant miscible dans l'eau qui, après durcissement, est capable de gonfler en cas d'exposition à l'eau, à une solution aqueuse alcaline ou à une solution aqueuse acide ;
un photo-amorceur ;
un composant non réactif et à faible toxicité ;
un agent tensioactif pour réduire la tension de surface à environ 30 mK/m (30 dynes/cm) ; et
un stabilisant ;
dans laquelle ladite composition a une viscosité supérieure à 50 mPa.s (50 cP) à température ambiante et une viscosité inférieure à 20 mPa.s (20 cP) à une température supérieure à 60 °C.

2. Composition selon la revendication 1, dans laquelle ledit composant miscible dans l'eau est un dérivé d'oligomère uréthane acrylé de polyéthylène glycol, un oligomère de polyol partiellement acrylé, un oligomère acrylé ayant des substituants hydrophiles, ou toute combinaison de ceux-ci.

3. Composition selon la revendication 2, dans laquelle lesdits substituants hydrophiles sont des substituants acides, des substituants amino, des substituants hydroxy, ou toute combinaison de ceux-ci.

4. Composition selon la revendication 1, dans laquelle ledit photo-amorceur est un photo-amorceur radicalaire, un photo-amorceur cationique, ou toute combinaison de ceux-ci.

5. Composition selon la revendication 1, dans laquelle ledit composant non-réactif est du polyéthylène glycol, du méthoxy polyéthylène glycol, du glycérol, du polyol éthoxylé, ou du propylèneglycol.

6. Composition selon la revendication 1, dans laquelle la composition est une composition durcissable apte à la solidification lors du durcissement.

7. Composition selon la revendication 1, comprenant en outre une substance libérant des bulles capable de produire du gaz en cas d'exposition à une solution aqueuse, à une solution aqueuse alcaline ou à une solution aqueuse acide.

8. Composition selon la revendication 7, dans laquelle ladite substance libérant des bulles est du bicarbonate de sodium, du carbonate de calcium ou une combinaison de ceux-ci.

9. Composition selon la revendication 1, dans laquelle, lors du durcissement, ladite composition est au moins partiellement soluble dans l'eau.

10. Composition selon la revendication 1, dans laquelle, lors du durcissement, un matériau solide est formulé comme matériau durcissable faible capable de se briser en cas d'exposition à de l'eau.

11. Composition selon la revendication 1, dans laquelle, lors du durcissement, une composition solide est formulée qui peut être facilement pulvérisée à la main ou à l'aide d'eau.

12. Composition solide formée par durcissement de la composition selon l'une quelconque des revendications 1 à 11.
